# DEMANDE DE BREVET EUROPEEN

(11) **EP 1 005 120 A1**
(43) Date de publication de la demande: **31.05.2000**
(21) Numéro de dépôt: 99402900.7
(22) Date de dépôt: 22.11.1999
(51) Int. Cl.: H01S 5/026, H01L 33/00, H01L 31/0232, G02B 6/122, G02B 6/13, G02B 6/42

(54) **Composant optique à semi-conducteur comportant un adaptateur de mode**

(30) Priorité: 24.11.1998 FR 9814804
(71) Demandeur: ALCATEL, 75008 Paris (FR)
(72) Inventeur: Lestea, Alexis, 94230 Cachan (FR); Colson, Véronique, 94230 Cachan (FR)
(74) Mandataire: Ballot, Paul

(57) **Abrégé**

L' invention concerne un composant optique à semi-conducteur comportant un adaptateur de mode permettant d'assurer le déconfinement du mode optique. Ce composant comporte un guide d'onde actif (24) et un guide d'onde passif (22) superposés et enterrés dans une couche de gaine (27). Il est caractérisé en ce qu'il comprend successivement: une section de couplage évanescent (SC), dans laquelle la largeur du guide d'onde actif (24) décroît et la largeur du guide d'onde passif (22) augmente ; et une section d'expansion de mode (SE) comprenant uniquement le guide d'onde passif (22) dont la largeur décroît.

## Description

L'invention se situe dans le domaine des composants optiques à semi-conducteurs utilisés pour la transmission optique ou le traitement de données numériques optiques.

Elle se rapporte plus particulièrement à tous les composants optiques comportant des guides d'ondes actif et passif enterrés dans des couches de gaine, tels que par exemple des lasers à semi-conducteur, des amplificateurs à semi-conducteur, ou encore des modulateurs par exemple.

Actuellement, on cherche à réduire au maximum le coût des modules optiques. La part la plus importante du coût est le plus souvent due à l'assemblage entre un tel composant et une fibre optique, par exemple, car il faut coupler des modes optiques de tailles très différentes. Ainsi, lorsque l'on assemble un laser et une fibre optique monomode clivée droite, il faut coupler le mode optique du laser, dont le diamètre est par exemple de l'ordre de 2µm, avec le mode optique de la fibre optique dont le diamètre est bien supérieur, par exemple de l'ordre de 9µm.

Pour pouvoir coupler ces modes optiques de tailles très différentes, on réalise des adaptateurs de mode afin d'accroître la taille du mode à la sortie du composant optique et de rendre son profil compatible avec celui du mode guidé dans la fibre optique. Cependant cette adaptation de mode doit être réalisée tout en conservant les performances du composant. Ainsi, pour un laser à semi-conducteur par exemple, il faut pouvoir conserver ses performances en termes de courant seuil et de rendement différentiel. Il faut en effet que, sur la gamme de température d'utilisation (en général comprise entre -40°C et +85°C), le composant laser présente un courant seuil le plus faible possible et un rendement différentiel le plus important possible. Pour conserver ainsi les performances du composant, et ne pas dégrader les paramètres de courant seuil et de rendement différentiel, il apparaît préférable de réaliser l'expansion du mode optique dans un guide d'onde passif.

Plusieurs solutions ont déjà été envisagées pour déconfiner le mode optique d'un composant. Une première méthode, dite de "butt coupling", permettant de coupler un guide d'onde passif à un guide d'onde actif, est très courante aujourd'hui. Les schémas des figures lA et 1B représentent respectivement une vue de dessus en coupe et une vue en coupe longitudinale d'un composant optique intégré lors de sa fabrication par la méthode de "butt coupling".

Cette méthode consiste, dans un premier temps, à faire croître sur un substrat 1, une première couche 5 constituant le guide d'onde actif, formée par exemple d'un matériau quaternaire, et à l'enterrer dans une couche de gaine 6 constituée par exemple d'InP. Une gravure locale de ces deux couches 5 et 6 est ensuite pratiquée, selon un procédé de gravure classique, sur une zone réservée à l'intégration d'un guide d'onde de type passif. Une reprise d'épitaxie permet de réaliser ce guide d'onde passif. Pour cela, une couche de matériau quaternaire 2, apte à jouer le rôle du guide d'onde passif, est déposée sur le substrat 1, dans la zone préalablement gravée localement, puis elle est enterrée dans une couche de gaine 3 en InP par exemple. La structure du guide d'onde actif 5 est différente de celle du guide d'onde passif 2. L'interface de couplage 7 entre les deux types de guides d'onde est dénommée "butt-joint" en terminologie anglo-saxonne. De plus, pour pouvoir déconfiner le mode optique, l'épaisseur du guide passif 2 décroît régulièrement tout le long de la section passive.

Cette méthode de fabrication est actuellement très bien maîtrisée. Cependant, elle nécessite une étape supplémentaire de gravure et de reprise d'épitaxie, ce qui contribue à augmenter le prix de revient du composant. De plus, pour aligner les guides actif et passif, la tolérance à l'alignement reste faible. Le couplage bout à bout, bien que correctement maîtrisé, reste une étape critique. Cette méthode restant relativement complexe à mettre en oeuvre, elle implique des coûts encore élevés.

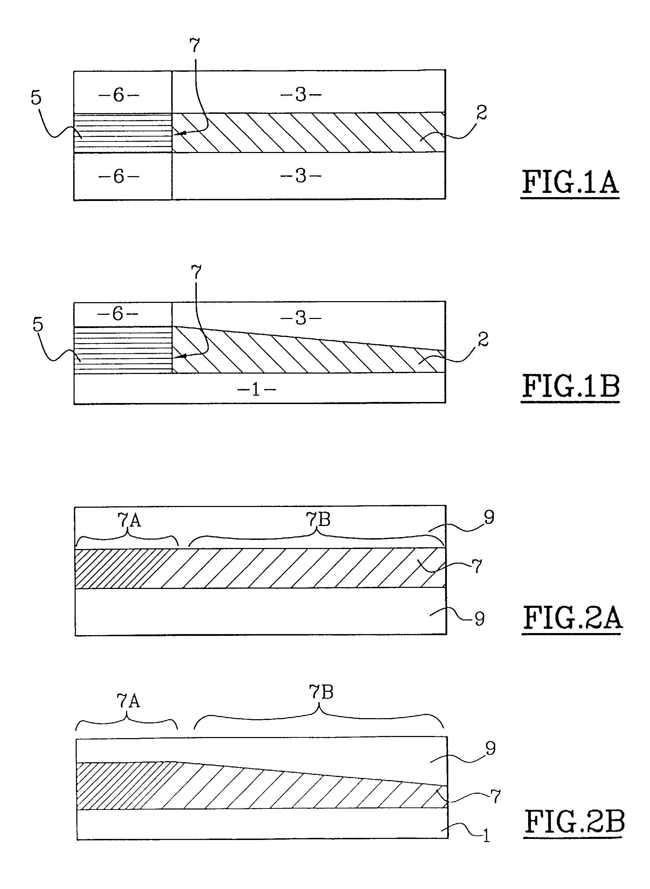

Une deuxième méthode, dite de croissance sélective par épitaxie, a été envisagée. Elle est schématisée sur les figures 2A et 2B qui représentent respectivement une vue de dessus en coupe et une vue en coupe longitudinale d'un composant optique intégré lors de sa fabrication. Cette méthode consiste à faire varier de manière continue la composition d'un guide d'onde 7 pour le faire passer progressivement d'un état de guide d'onde actif 7A à un état de guide d'onde passif 7B. La croissance sélective du matériau de constitution du guide d'onde 7 est réalisée, sur un substrat 1, en utilisant deux masques diélectriques, en silice (SiO₂) ou en nitrure de silicium (Si₃N₄) par exemple, placés cote à cote. Les espèces en croissance ne se déposent pas sur ces masques et il se crée un phénomène de diffusion des espèces en croissance. La forme des masques est déterminée pour que le phénomène de diffusion des espèces soit plus ou moins prononcé selon les régions considérées du guide d'onde. De même que dans la méthode de "butt coupling", l'épaisseur du guide d'onde, dans la section passive 7B, décroît progressivement afin de permettre le déconfinement du mode optique et donc l'élargissement de sa taille. Le guide 7A, 7B est par ailleurs enterré dans une couche de gaine 9.

Cette deuxième méthode présente l'avantage de ne comporter qu'une seule étape d'épitaxie. Cependant, elle ne permet pas d'optimiser les deux guides d'onde actif 7A et passif 7B séparément, si bien qu'elle nécessite de faire des compromis. De plus, cette méthode ne permet pas de définir clairement la frontière entre les deux types de guides actif et passif, car le changement d'état est progressif. Le fait de ne pas savoir définir cette frontière est pénalisant car il est difficile de savoir où positionner l'électrode nécessaire au fonctionnement du composant. Cette électrode doit en effet être positionnée au dessus du guide actif pour assurer le bon fonctionnement du composant. En revanche, si elle recouvre une partie du guide passif, il se crée des fuites électriques qui pénalisent et dégradent les paramètres de courant seuil et de rendement différentiel.

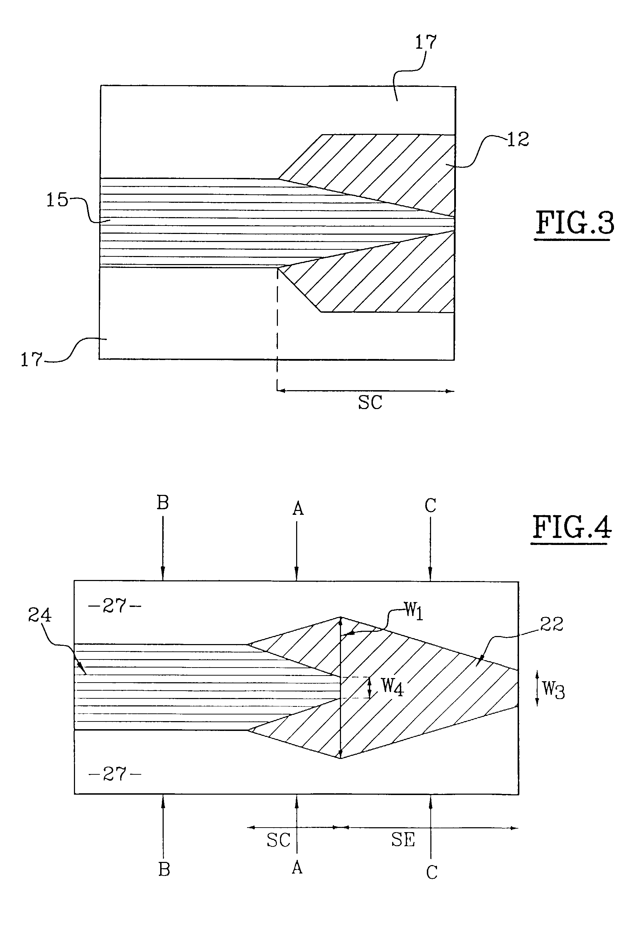

Une troisième solution envisagée, pour réaliser un adaptateur de mode intégré dans un composant optique, est schématisée sur la vue de dessus en coupe de la figure 3. Cette solution consiste à superposer un guide d'onde actif 15 et un guide d'onde passif 12, de manière à créer une zone de couplage vertical évanescent SC, dans laquelle la largeur du guide d'onde actif 15 décroît progressivement pour assurer le déconfinement du mode, et la largeur du guide d'onde passif 12 augmente très rapidement puis devient constante sur toute la longueur de cette section. Les deux guides actif 15 et passif 12 sont en outre enterrés dans une couche de gaine 17. Dans ce cas, la longueur de la section de couplage SC doit être suffisante pour permettre un déconfinement complet du mode optique dans tout le guide actif. Cette longueur est en général supérieure à 150µm. De plus, au fur et à mesure de son déconfinement, le mode optique transite dans le guide passif 12. Le guide passif présente une largeur constante de l'ordre de 4µm, et une épaisseur très fine de l'ordre de 50nm pour permettre le déconfinement du mode. Une épaisseur trop élevée de ce guide passif empêcherait en effet le déconfinement du mode dans le guide actif. C'est pourquoi, le guide passif présente en général une épaisseur inférieure à 100nm.

L'inconvénient majeur de cette solution réside dans le fait que le déconfinement du mode est entièrement réalisé dans le guide actif, ce qui entraîne une dégradation des performances du composant, notamment de son courant seuil et de son rendement différentiel. De plus, les pertes optiques de couplage avec une fibre optique monomode restent encore élevées; elles sont de l'ordre de 4,5dB.

La présente invention permet de résoudre les problèmes liés aux composants de l'art antérieur. Elle propose pour cela un composant optique comportant un adaptateur de mode intégré, dans lequel deux guides d'onde actif et passif sont superposés et présentent chacun une configuration particulière pour assurer une adaptation de mode de bonne qualité. L'adaptation du mode optique, dans le composant selon l'invention, se fait principalement dans le guide d'onde passif.

L'invention se rapporte plus particulièrement à un composant optique à semi-conducteur, comportant un guide d'onde actif et un guide d'onde passif superposés et enterrés dans une couche de gaine, caractérisé en ce qu'il comprend successivement:
- une section de couplage évanescent, dans laquelle la largeur du guide d'onde actif décroît et la largeur du guide d'onde passif augmente, et
- une section d'expansion de mode comprenant uniquement le guide d'onde passif dont la largeur décroît.

Selon une autre caractéristique de l'invention, le composant comprend en outre une section de transition, disposée entre la section de couplage évanescent et la section d'expansion de mode, dans laquelle la largeur du guide d'onde actif décroît jusqu'à 0µm.

Selon une autre caractéristique de l'invention, le guide passif présente une épaisseur comprise entre 100 et 200nm. La longueur de la section de couplage évanescent est de préférence inférieure ou égale à 200µm. La longueur de la section de transition est comprise entre 0 et 10µm.

Selon une autre caractéristique de l'invention, la largeur du guide d'onde passif, dans la section de couplage évanescent, augmente jusqu'à une valeur comprise entre 2 et 3µm.

Selon une autre caractéristique de l'invention, la largeur du guide d'onde passif, dans la section de transition, peut varier et présenter une discontinuité.

Selon une autre caractéristique, la largeur du guide d'onde passif, dans la section d'expansion de mode, décroît jusqu'à une valeur comprise entre 0,2 et 0,9µm.

Selon une autre caractéristique, la largeur du guide d'onde actif, dans la section de couplage évanescent, décroît jusqu'à une valeur de l'ordre de 0,3µm.

La présente invention permet de réaliser un composant optique comportant un adaptateur de mode intégré, dans lequel le mode optique est principalement déconfiné dans le guide passif si bien que le courant seuil et le rendement différentiel du composant ne sont pas affectés. Les guides d'ondes passif et actif ne sont pas alignés mais ils sont couplés verticalement, si bien que les problèmes liés à l'alignement sont évités. De plus, les deux types de guide actif et passif peuvent être optimisés séparément.

D'autres particularités et avantages de l'invention apparaîtront à la lecture de la description donnée à titre d'exemple illustratif et faite en référence aux figures annexées qui représentent :
- les figures 1A et 1B , déjà décrites, respectivement une vue de dessus en coupe et une vue en coupe longitudinale d'un premier mode de réalisation connu d'un composant optique comportant un adaptateur de mode intégré,
- les figures 2A et 2B, déjà décrites, respectivement une vue de dessus en coupe et une vue en coupe longitudinale d'un deuxième mode de réalisation connu d'un composant optique comportant un adaptateur de mode intégré,
- la figure 3, déjà décrite, une vue de dessus en coupe d'un autre composant de l'art antérieur comportant un adaptateur de mode intégré,
- la figure 4, une vue de dessus en coupe d'un composant selon un premier mode de réalisation de l'invention,
- les figures 5A à 5F, des vues en coupe transversales du composant de la figure 4 au cours de différentes étapes de sa fabrication,
- les figures 6A et 6B, respectivement une vue de dessus en coupe et une vue en coupe longitudinale d'un composant selon un deuxième mode de réalisation de l'invention.

Un composant optique à semi-conducteur selon un premier mode de réalisation de l'invention est schématisé en vue de dessus et en coupe sur la figure 4. Ce composant comporte un guide d'onde actif 24 et un guide d'onde passif 22. Les deux guides d'onde 24 et 22 sont superposés et sont en outre enterrés dans une couche de gaine 27.

Une section de couplage vertical évanescent, référencée SC sur la figure 4, permet de transférer le mode optique guidé du guide actif 24 vers le guide passif 22. Dans cette section SC, la largeur du guide d'onde actif 24 décroît et la largeur du guide d'onde passif augmente. Le cas idéal pour transférer un mode optique d'un guide actif vers un guide passif sans aucune perte optique consisterait à réaliser un guide d'onde actif configuré en pointe, c'est à dire dont la largeur décroît jusqu'à 0µm. Cependant, la technologie utilisée actuellement ne permet pas encore de maîtriser correctement la réalisation de telles pointes et, en général, la largeur du guide actif est très bien maîtrisée jusqu'à une valeur de l'ordre de 0,3µm. Par conséquent, dans le premier mode de réalisation, la largeur du guide actif 24 décroît, dans la section de couplage SC, jusqu'à une valeur W₄ de l'ordre de 0,3 µm. Cette largeur W₄ de 0,3µm crée une discontinuité entre les deux guides d'onde actif 24 et passif 22.

Pour que le mode optique soit transféré dans le guide passif 22 sans trop de pertes optiques, c'est à dire pour que la transition du mode optique d'un guide à l'autre soit la moins perturbée possible par la discontinuité ainsi créée, le guide passif 22 doit présenter une configuration telle qu'il permet d'empêcher le guide actif 24 d'exercer une quelconque influence sur le guidage optique. Pour cela, le guide passif 22 présente une épaisseur relativement élevée. De préférence, cette épaisseur est comprise entre 100 et 200nm. Dans l'exemple, elle est de 150 nm. Le guide actif, quant à lui, présente une épaisseur de l'ordre de 300nm. De plus, dans cette section SC, la largeur du guide passif 22 augmente afin d'améliorer la qualité du couplage optique.

Le composant optique comporte d'autre part une deuxième section, dite section d'expansion de mode et référencée SE sur la figure 4. Cette section permet d'assurer le déconfinement du mode. Elle comprend uniquement le guide passif 22 dont la largeur décroît progressivement afin de permettre l'élargissement (c'est à dire le déconfinement) de la taille du mode optique. De préférence, la largeur du guide décroît jusqu'à une valeur W₃ comprise entre 0,2 et 0,9µm.

La longueur de cette section d'expansion de mode SE est très importante car le déconfinement du mode optique se fait principalement dans cette section passive. Elle doit donc être suffisante pour permettre un déconfinement suffisant du mode optique. Typiquement, cette longueur est comprise entre 100 et 500µm. La longueur de la section de couplage évanescent SC, quant à elle, est de préférence inférieure à 200µm. Le couplage entre les deux types de guides n'est en effet pas amélioré pour une longueur supérieure.

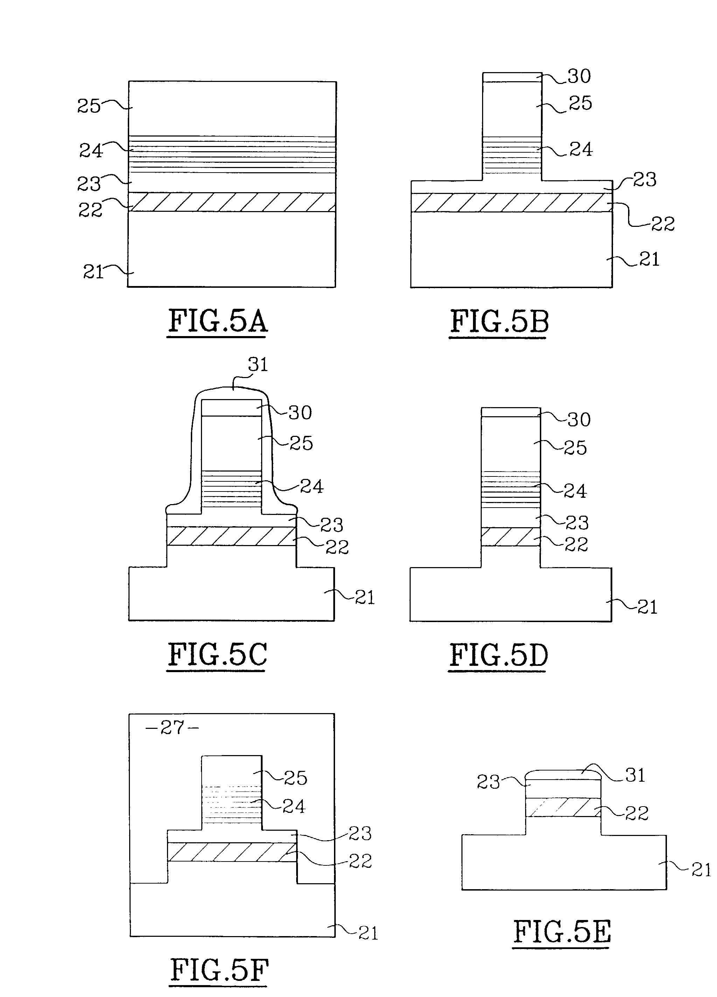

Les figures 5A à 5F illustrent les différentes étapes d'un procédé de fabrication de ce composant. Bien sûr, le procédé qui est décrit dans ce qui suit n'est qu'un exemple illustratif et l'invention ne se limite pas à ce procédé particulier; elle s'étend à tous les procédés de fabrication qui permettent de réaliser ce type de composant.

Une première étape du procédé, illustrée sur la vue en coupe transversale de la figure 5A, consiste à définir la structure verticale du composant. Cette structure verticale est réalisée sur un substrat 21 en matériau III-V par exemple, tel qu'un phosphure d'indium InP. L'empilement des couches est réalisé selon un procédé classique d'épitaxie, par exemple selon un procédé d'épitaxie par jets moléculaires ("MBE"). Cet empilement comporte, de bas en haut, une première couche 22 en matériau quaternaire, par exemple en InGaAsP, destinée à former le guide d'onde passif; une couche tampon 23 en InP par exemple; une autre couche 24 en matériau quaternaire et présentant une structure à multi-puits quantiques par exemple, destinée à former le guide d'onde actif; et enfin une couche tampon supérieure 25 en InP par exemple.

Après avoir réalisé cette structure verticale, il faut définir la configuration des deux guides d'ondes 22 et 24. Pour cela, on réalise une première lithographie destinée à définir le guide actif 24, en utilisant un masque 30 en silice par exemple (figure 5B). L'étape suivante consiste ensuite à définir le guide passif 22. Pour cela, on réalise une deuxième lithographie, en utilisant un autre masque 31, en résine par exemple. Les figures 5C à 5E représentent cette deuxième lithographie. La figure 5C représente plus particulièrement une vue en coupe transversale selon A-A de la figure 4 au cours de cette deuxième lithographie, la figure 5D représente une vue en coupe transversale selon B-B de la figure 4 au cours de cette deuxième lithographie, et la figure 5E représente une vue en coupe transversale selon C-C de la figure 4.

Une dernière étape du procédé, illustrée sur la figure 5F, consiste ensuite à supprimer les masques 30 et 31, selon un procédé connu de l'homme de l'art, puis à réaliser une reprise d'épitaxie pour enterrer les guides d'onde 22 et 24 ainsi configurés dans une couche de gaine 27, en InP par exemple. La figure 5F, représente plus particulièrement le cas où le ruban de guide d'onde réalisé est de type "BRS" (Buried Ridge Stripe en littérature anglo-saxonne). Dans ce cas, le substrat 21 est dopé en porteurs d'un premier type (en porteurs de type n par exemple), tandis que la couche de gaine 27 est dopée en porteurs d'un deuxième type (en porteurs de type p dans l'exemple). Ce cas n'est cependant qu'un exemple et bien sûr l'invention ne se limite pas à ce type de structure. Ainsi, dans d'autres exemples, on peut aussi réaliser des reprises d'épitaxie de structures dites pnBH ou de structures dites SIBH, bien connues de l'homme de l'art, et comportant respectivement des couches latérales bloquantes ou des couches latérales semi-isolantes.

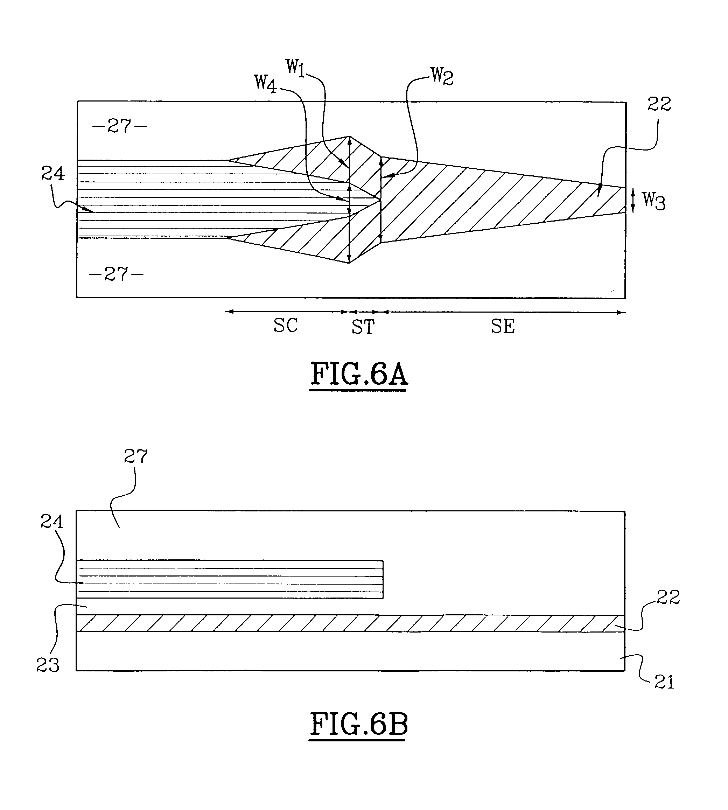

Les figures 6A et 6B représentent respectivement une vue de dessus en coupe et une vue en coupe longitudinale d'un composant optique selon un deuxième mode de réalisation de l'invention. Dans ce mode de réalisation, le composant comporte une troisième section, dite section de transition ST, disposée entre la section de couplage évanescent SC et la section d'expansion de mode SE. Dans cette section de transition ST, la largeur du guide d'onde actif 24 décroît très rapidement jusqu'à 0µm (qui est la valeur idéale) ou une valeur très voisine de 0µm, par exemple 0,1µm.

Cette section ST n'est pas indispensable au fonctionnement du composant et à l'adaptation du mode optique, mais elle permet d'améliorer le couplage entre les deux types de guides actif 24 et passif 22 car, dans ce cas, la discontinuité entre le guide actif 22 et le guide passif 24 est considérablement réduite, voire même supprimée dans le cas idéal où la largeur du guide décroît jusqu'à 0µm. La longueur de cette section ST est de préférence comprise entre 0 et 10µm.

De plus, dans cette section de transition ST, la largeur du guide passif 22 peut éventuellement présenter une discontinuité. En fait, la largeur du guide passif peut varier, sur toute la longueur de cette section ST, dans le sens d'une augmentation ou bien dans le sens d'une réduction, selon la structure du guide d'onde actif.

Dans l'exemple de la figure 6A, la largeur du guide d'onde passif 22 décroît dans cette section ST. Cette variation de largeur du guide passif dans la section de transition ST permet également d'améliorer le couplage optique entre les deux types de guides. La largeur du guide passif 22 varie donc d'une valeur W₁ à une valeur W₂. Ces deux valeurs sont du même ordre de grandeur et comprises entre 2µm et 3µm. Dans tous les cas, la largeur du guide passif 22 est de préférence inférieure à 3µm car, au-delà de cette valeur, la structure guidante du composant devient bimode et non plus monomode. Bien sûr, cette limitation concerne l'exemple du couplage entre un composant optique, tel qu'un laser par exemple, et une fibre optique monomode.

La largeur du guide passif 22 décroît progressivement tout le long de la section d'expansion de mode SE, jusqu'à une valeur W₃ comprise entre 0,2 et 0,9µm. Cette réduction progressive de la largeur du guide passif 22 permet de déconfiner le mode optique.

La vue en coupe longitudinale de la figure 6B représente les guides d'onde actif 24 et passif 22 dans leur épaisseur. Le guide passif 22 présente une épaisseur comprise entre 100 et 200nm, et le guide actif 24 présente une épaisseur de l'ordre de 300nm. Leur épaisseur reste constante dans tout le composant.

Grâce à la présente invention, les deux guides d'onde actif et passif sont déposés en une seule étape d'épitaxie, et la couche de confinement (ou couche de gaine 27) est ensuite déposée dans une seconde épitaxie après avoir configuré les guides. La taille du mode optique en sortie du composant est entièrement déterminée par la configuration du guide passif, notamment l'extrémité de ce guide, si bien que cette solution s'adapte pour n'importe quelle structure de guide actif. L'énergie est transférée du guide actif vers le guide passif épais avec une petite taille de mode, et le mode optique est principalement déconfiné dans le guide passif, si bien que la section de couplage peut être relativement courte, c'est à dire inférieure à 200µm. Seule la section d'expansion de mode doit être d'une longueur suffisante pour permettre un bon déconfinement du mode. De plus, les guides passif 22 et actif 24 étant bien séparés, ils peuvent être optimisés de manière indépendante et ne nécessitent pas de faire des compromis. Enfin, étant donné que les deux guides sont superposés et non pas couplés bout à bout, il n'y a pas de problèmes d'alignement et d'ajustement.

Pour illustrer les résultats obtenus grâce à l'invention, un composant optique de type Fabry-Perot, émettant à la longueur d'onde de 1,3µm, et comportant un adaptateur de mode dans un guide passif configuré de la manière décrite précédemment, a été réalisé. La section de couplage évanescent SC a été réalisée sur une longueur de 70µm, la section d'expansion de mode SE a été réalisée sur une longueur de 120µm, et la section de transition ST a été réalisée sur une longueur de 10µm. Les résultats obtenus avec ce composant sont satisfaisants. Les pertes optiques de couplage, notamment, sont de l'ordre de 3,2 dB, et la taille du mode optique, dont le diamètre initial est de l'ordre de 2µm, peut être élargie jusqu'à un diamètre de l'ordre de 9µm.

## Revendications

1. Composant optique à semi-conducteur, comportant un guide d'onde actif (24) et un guide d'onde passif (22) superposés et enterrés dans une couche de gaine (27), caractérisé en ce qu'il comprend successivement:
- une section de couplage évanescent (SC), dans laquelle la largeur du guide d'onde actif (24) décroît et la largeur du guide d'onde passif (22) augmente, et
- une section d'expansion de mode (SE) comprenant uniquement le guide d'onde passif (22) dont la largeur décroît.

2. Composant selon la revendication 1, caractérisé en ce qu'il comprend en outre une section de transition (ST), disposée entre la section de couplage évanescent (SC) et la section d'expansion de mode (SE), dans laquelle la largeur du guide d'onde actif (24) décroît jusqu'à 0µm.

3. Composant selon l'une des revendications 1 à 2, caractérisé en ce que le guide d'onde passif (22) présente une épaisseur comprise entre 100 et 200nm.

4. Composant selon l'une des revendications 1 à 3, caractérisé en ce que la longueur de la section de couplage évanescent (SC) est inférieure ou égale à 200µm.

5. Composant selon l'une des revendications 1 à 4, caractérisé en ce que la longueur de la section d'expansion de mode (SE) est comprise entre 100 et 500 µm.

6. Composant selon l'une des revendications 1 à 5, caractérisé en ce que la longueur de la section de transition (ST) est comprise entre 0 et 10µm.

7. Composant selon l'une des revendications 1 à 6, caractérisé en ce que la largeur du guide d'onde passif (22), dans la section de couplage évanescent (SC), augmente jusqu'à une valeur (W₁) comprise entre 2 et 3µm.

8. Composant selon l'une quelconque des revendications précédentes, caractérisé en ce que la largeur du guide d'onde passif (22), dans la section de transition (ST), peut varier (W₁, W₂) et présenter une discontinuité.

9. Composant selon l'une quelconque des revendications précédentes, caractérisé en ce que la largeur du guide d'onde passif (22), dans la section d'expansion de mode (SE), décroît jusqu'à une valeur (W₃) comprise entre 0,2 et 0,9µm.

10. Composant selon l'une quelconque des revendications précédentes, caractérisé en ce que la largeur du guide d'onde actif (24), dans la section de couplage évanescent (SC), décroît jusqu'à une valeur (W₄) de l'ordre de 0,3µm.
